# FASCICULE DE BREVET EUROPEEN

(11) **EP 3 867 192 B1**
(45) Date de publication et mention de la délivrance du brevet: **29.04.2026**
(21) Numéro de dépôt: 19791211.6
(22) Date de dépôt: 18.10.2019
(51) Int. Cl.: B81C 99/00

(54) **PROCÉDÉ ET DISPOSITIF DE DÉPÔT D'UN NANO-OBJET**
VERFAHREN UND VORRICHTUNG ZUR ABSCHEIDUNG EINES NANOOBJEKTS
METHOD AND DEVICE FOR DEPOSITING A NANO-OBJECT

(30) Priorité: 18.10.2018 FR 1859645
(43) Date de publication de la demande: 25.08.2021
(73) Titulaire: Centre national de la recherche scientifique, 75016 Paris (FR); Ecole Normale Supérieure, 75005 Paris (FR); Sorbonne Université, 75006 Paris (FR); Université de Paris, 75006 Paris (FR)
(72) Inventeur: DELBECQ, Matthieu, 92160 Antony (FR); CUBAYNES, Tino, 69126 Heidelberg (FR); PALOMO, José, 95100 Argenteuil (FR); DARTIAILH, Matthieu, New York, New York 10003 (US); KONTOS, Takis, 75013 Paris (FR); DESJARDINS, Matthieu, 75018 Paris (FR)
(74) Mandataire: Hautier IP
(86) Numéro de dépôt international: PCT/EP2019/078380
(87) Numéro de publication internationale: WO 2020/079228

(56) Documents cités:
- US-A1- 2002 061 662
- JÖRG GRAMICH ET AL: "Fork stamping of pristine carbon nanotubes onto ferromagnetic contacts for spin-valve devices : Stamping CNTs onto ferromagnetic contacts", PHYSICA STATUS SOLIDI. B, BASIC RESEARCH., vol. 252, no. 11, 1 November 2015 (2015-11-01), DE, pages 2496 - 2502, XP055603147, ISSN: 0370-1972, DOI: 10.1002/pssb.201552213

## Description

### Domaine technique

La présente invention concerne un procédé et un dispositif de dépôt d'un nano-objet.

Un tel dispositif permet à un utilisateur de déposer un nano-objet sur une surface.

### Etat de la technique antérieure

L'intégration de nano-objets sur un composant électronique permet de fabriquer des dispositifs capables d'atteindre les limites quantiques. Les comportements quantiques étant très sensibles à leur environnement, il est crucial de disposer d'un matériau d'une grande pureté pour l'ingénierie de technologies quantiques. Les nanotubes de carbone sont des matériaux à la cristallinité exceptionnelle, ce qui leur permet d'être aussi résistant mécaniquement que le diamant tout en ayant une conductivité électronique record, les électrons étant cent fois plus mobiles que dans le silicium. L'information peut être encodée sous forme quantique dans le spin d'un électron et les nanotubes de carbone sont un matériau hôte idéal pour ces électrons grâce à leur grande pureté cristalline. Les nanotubes de carbone ont aussi une réponse optique couvrant un spectre du visible jusqu'au proche infrarouge suivant la taille de leur diamètre. Ils sont donc aussi intégrés à des dispositifs optiques ou optoélectroniques. Ces nano-objets sont aussi intégrés sur des composants silicium pour réaliser des capteurs, très sensibles grâce au ratio surface/volume inégalé de ce matériau.

Ces propriétés sont cependant dégradées par les défauts ou les pollutions sur le nanotube. Les nanotubes de carbone présentent de plus une diversité de structure cristalline lors de leur croissance et ont tendance à s'agglomérer. La capacité à isoler et à manipuler un objet unique sans le dégrader permet d'apporter un contrôle accru sur le comportement du dispositif l'utilisant. Aussi la fabrication de circuits électroniques avec des encres ou des couches minces ne permet pas un contrôle optimal des caractéristiques du composant fabriqué. Les encres présentent de plus des additifs chimiques qui modifient l'environnement du nanotube, problème que l'on retrouve aussi dans les nanotubes en solution. De même, l'intégration avec des techniques de lithographie électronique dégrade la structure cristalline du nanotube à cause de l'utilisation de résine et d'un microscope électronique.

L'intégration d'un nanotube unique, sans pollution ni défaut et aux caractéristiques cristallines identifiées permet de conserver les propriétés des nanotubes, et assure une reproductibilité et un plus grand contrôle des dispositifs. De plus, la dégradation du nanotube et la présence de pollution a un impact sur le taux de succès de l'intégration, qui dépend crucialement de la qualité du contact entre le nanotube et le substrat cible.

Pour éviter les défauts sur le nanotube, une méthode consiste à le transférer mécaniquement suspendu sur un support vers le substrat cible. Ceci est réalisé en dernière étape de fabrication pour préserver le nanotube de toutes dégradations.

On connaît de tels procédés de dépôt d'un nano-objet tel qu'un nanotube de carbone, comme par exemple décrits par :
- « One-Step Direct Transfer of Pristine Signe-Walled Carbon Nanotubes for Functional Nanoelectronics » de Chung Chiang Wu et al., Nanoletters 2010, 10, 1032-1036
- « Fork stamping of pristine carbone nanotubes onto ferromagnetic contacts for spin-valve devices » de J. Gramich et al., Phys. Status Solidi B 252, 2496 (2015)

Le but de la présente invention est de résoudre au moins un des problèmes de tels procédés selon l'état de l'art, et notamment de proposer un procédé et un dispositif de dépôt d'un nano-objet permettant :
- d'obtenir des échantillons ou composants plus propres et/ou un transfert plus systématique, et/ou
- un meilleur contrôle de l'interface entre le nano-objet et le substrat cible, et/ou
- un meilleur taux d'intégration du nano-objet, et/ou
- une meilleur reproductibilité du dépôt ou de l'intégration du nano-objet, et/ou
- une meilleure stabilité du dispositif réalisé, et/ou
- une meilleure rapidité d'exécution, et/ou
- augmenter la surface disponible sur le substrat cible, en limitant les zones de contact entre le support et le substrat cible lors du transfert, ces zones de contact étant généralement définies par des fosses dans le substrat cible.

### Exposé de l'invention

Cet objectif est atteint avec un procédé de dépôt d'un objet (de préférence d'un nano-objet) comprenant:
- une approche, dans une enceinte, d'un support en direction d'un substrat porteur, le support portant un objet (de préférence un nano-objet) à transférer, le support étant de préférence un peigne comprenant au moins deux dents, dont une paire de dents voisines porte un objet (de préférence un nano-objet) à transférer étendu entre les deux dents de la paire, puis
- un transfert, dans l'enceinte, de l'objet à partir du support et vers une zone de dépôt du substrat porteur (de préférence alors que la zone de dépôt est située entre les deux dents de la paire dans le cas d'un peigne).

L'étape de transfert est de préférence réalisée alors que l'intérieur de l'enceinte est sous vide à une pression inférieure à 10⁻⁶ bar.

L'approche peut comprendre un contrôle optique :
- d'une inclinaison du support par rapport à la zone de dépôt, et/ou
- d'une position relative entre le support et la zone de dépôt, et/ou
- d'au moins un angle entre le support et la zone de dépôt.

Le procédé selon l'invention (de préférence l'étape d'approche) peut comprendre un réglage, depuis l'extérieur de l'enceinte :
- d'une inclinaison du support par rapport à la zone de dépôt à l'intérieur de l'enceinte, et/ou
- d'une position relative entre le support et la zone de dépôt à l'intérieur de l'enceinte, et/ou
- d'au moins un angle entre le support et la zone de dépôt à l'intérieur de l'enceinte.

Pendant l'étape de réglage :
- le support est de préférence mobile par rapport à l'enceinte, et
- la zone de dépôt est de préférence immobile par rapport à l'enceinte.

Le transfert peut être réalisé à une température à l'intérieur de l'enceinte supérieure à -50°C et/ou inférieure à +90°C.

La température à l'intérieur de l'enceinte peut être égale à une température à l'extérieur de l'enceinte.

Le procédé selon l'invention peut comprendre une encapsulation, dans l'enceinte et sous vide à une pression inférieure à 10⁻⁶ bar, de l'objet transféré.

Le substrat porteur peut comprendre, de part et d'autre de la zone de dépôt, des fosses dans lesquelles sont insérées les dents du support lors du transfert dans le cas où ce support est un peigne.

La zone de dépôt peut comprendre des électrodes ou un circuit électronique, de sorte que ces électrodes et/ou le circuit électronique soit en contact, à la fin de l'étape de transfert, avec l'objet à transférer.

Le procédé selon l'invention peut comprendre, pendant l'étape de transfert, une mesure électrique entre deux électrodes de mesure de la zone de dépôt.

La zone de dépôt peut comprendre deux paires d'électrodes dites de coupe , le transfert comprenant de préférence une circulation de courant électrique entre chaque paire d'électrodes de coupe de manière à couper l'objet entre chaque paire d'électrodes de coupe.

Le procédé selon l'invention peut comprendre, avant l'étape d'approche, un nettoyage de la zone de dépôt à l'intérieur de l'enceinte, de préférence :
- par un canon à ions, de préférence par un canon à ions Argon, et/ou
- par un décapage d'une couche protectrice avec un plasma qui grave sélectivement cette couche protectrice.

Le nettoyage est de préférence réalisé alors que l'intérieur de l'enceinte est sous vide à une pression inférieure à 10⁻⁶ bar.

Le vide à une pression inférieure à 10⁻⁶ bar est de préférence conservé de l'étape de nettoyage jusqu'à l'étape de transfert.

Le support est de préférence isolé du substrat dans une zone distincte, dite zone tampon qui est séparée de l'enceinte par une vanne fermée lors de l'étape de nettoyage.

L'objet à transférer peut comprendre ou consister en un nanotube et/ou une nano-fibre et/ou un nano-fil et/ou un nanotube de carbone, et/ou du graphène et/ou une hétérostructure bidimensionnelle et/ou un nano-feuillet.

Le support :
- peut comprendre au moins cinq dents, de préférence au moins 25 dents, et/ou
- peut avoir des paires de dents voisines espacées d'un espace, défini selon une direction d'alignement des dents, supérieure à 5 µm et/ou inférieure à 100 µm, et/ou
- peut avoir des dents ayant chacune une largeur, définie selon une direction d'alignement des dents, supérieure à 5 µm et/ou inférieure à 100 µm, et/ou
- peut avoir des dents ayant chacune une longueur, définie selon une direction perpendiculaire à la direction d'alignement des dents, supérieure à 5 µm et/ou inférieure à 1000 µm.

Le procédé selon l'invention peut comprendre, avant l'étape d'approche, un dépôt ou une croissance de nanotubes de carbone sur le support comprenant :
- un dépôt de catalyseur sur le support, puis
- une croissance des nanotubes sur le support.

Le catalyseur peut ne pas être déposé de manière uniforme sur le support mais être déposé de manière localisée sur une surface inférieure à 500 µm² par dent à l'extrémité de plusieurs dents du support.

Le procédé selon l'invention peut comprendre, avant l'étape d'approche, une étape de localisation et/ou de sélection, sur le support, de l'objet à transférer.

La sélection peut comprendre une mesure de conductivité et/ou de chiralité et/ou de défauts de l'objet à transférer.

Suivant encore un autre aspect de l'invention, il est proposé un dispositif de dépôt d'un objet (de préférence d'un nano-objet), ledit dispositif comprenant:
- une enceinte
- des moyens agencés pour porter, dans une zone de support, un support, ledit support étant de préférence un peigne comprenant au moins deux dents,
- des moyens agencés pour porter un substrat dans une zone de dépôt,
- des moyens de mise sous vide agencés pour créer dans l'enceinte un vide à une pression inférieure à 10⁻⁶ bar,
- des moyens de manipulation agencés pour approcher, dans l'enceinte, la zone de support en direction de la zone de dépôt, de manière à permettre un transfert, dans l'enceinte, d'un objet (de préférence d'un nano-objet) à partir de la zone de support et vers la zone de dépôt.

Les moyens de manipulation sont de préférence agencés pour approcher, dans l'enceinte, la zone de support en direction de la zone de dépôt, de manière à permettre un transfert, dans l'enceinte, d'un objet (de préférence d'un nano-objet) de la zone de support vers la zone de dépôt alors que l'intérieur de l'enceinte est dans un vide à une pression inférieure à 10⁻⁶ bar créée par les moyens de mise sous vide.

Le dispositif selon l'invention peut comprendre des moyens de contrôle optique agencés pour contrôler optiquement :
- une inclinaison du support par rapport à la zone de dépôt, et/ou
- une position relative entre le support et la zone de dépôt, et/ou
- au moins un angle entre le support et la zone de dépôt.

Le dispositif selon l'invention peut comprendre des moyens de réglage agencés pour régler, depuis l'extérieur de l'enceinte :
- une inclinaison du support par rapport à la zone de dépôt à l'intérieur de l'enceinte, et/ou
- une position relative entre le support et la zone de dépôt à l'intérieur de l'enceinte, et/ou
- au moins un angle entre le support et la zone de dépôt à l'intérieur de l'enceinte.

Les moyens de réglage peuvent être agencés pour que la zone de support puisse être mobile par rapport à l'enceinte alors que la zone de dépôt est immobile par rapport à l'enceinte.

Les moyens de manipulation peuvent être agencés pour approcher, dans l'enceinte, la zone de support en direction de la zone de dépôt, de manière à permettre un transfert, dans l'enceinte, d'un objet (de préférence d'un nano-objet) de la zone de support vers la zone de dépôt alors que l'intérieur de l'enceinte est à une température supérieure à -50°C et/ou inférieure à +90°C.

Les moyens de manipulation peuvent être agencés pour approcher, dans l'enceinte, la zone de support en direction de la zone de dépôt, de manière à permettre un transfert, dans l'enceinte, d'un objet (de préférence d'un nano-objet) de la zone de support vers la zone de dépôt alors que la température à l'intérieur de l'enceinte est égale à une température à l'extérieur de l'enceinte.

Le dispositif selon l'invention peut comprendre des moyens d'encapsulation agencés pour encapsuler, dans l'enceinte et sous vide à une pression inférieure à 10⁻⁶ bar, un objet (de préférence un nano-objet) transféré dans la zone de dépôt.

Le dispositif selon l'invention peut comprendre des moyens électriques et/ou électroniques agencés pour se connecter à des électrodes ou un circuit électronique situé(es) dans la zone de dépôt.

Les moyens électriques et/ou électroniques peuvent comprendre des moyens pour effectuer une mesure électrique entre deux électrodes de mesure situées dans la zone de dépôt.

Les moyens électriques et/ou électroniques peuvent comprendre des moyens pour faire circuler un courant entre chaque paire d'électrodes de coupe situées dans la zone de dépôt de manière à couper un objet (de préférence un nano-objet) entre chaque paire d'électrodes de coupe.

Le dispositif selon l'invention peut comprendre des moyens de nettoyage agencés pour nettoyer la zone de dépôt à l'intérieur de l'enceinte, les moyens de nettoyage comprenant de préférence :
- un canon à ions, de préférence un canon à ions Argon, et/ou
- des moyens de décapage agencés pour décaper une couche protectrice par un plasma qui grave sélectivement cette couche protectrice.

Le dispositif selon l'invention peut comprendre une vanne agencée pour :
- dans une position fermée, isoler la zone de support par rapport à la zone de dépôt, et
- dans une position ouverte, ne pas isoler la zone de support par rapport à la zone de dépôt.

Suivant encore un autre aspect de l'invention, il est proposé un peigne comprenant au moins deux dents, dont au moins une paire de dents voisines porte un objet (de préférence d'un nano-objet) à transférer étendu entre les deux dents de la paire.

L'objet à transférer peut comprendre ou consister en un nanotube de carbone, un nano-fil et/ou du graphène ou une hétérostructure bidimensionnelle.

Le peigne peut comprendre :
- au moins cinq dents, de préférence au moins 25 dents, et/ou
- des paires de dents voisines espacées d'un espace, défini selon une direction d'alignement des dents, supérieure à 5 µm et/ou inférieure à 100 µm, et/ou
- des dents ayant chacune une largeur, définie selon une direction d'alignement des dents, supérieure à 5 µm et/ou inférieure à 100 µm, et/ou
- des dents ayant chacune une longueur, définie selon une direction perpendiculaire à la direction d'alignement des dents, supérieure à 5 µm et/ou inférieure à 1000 µm.

Un catalyseur de croissance de nano-objets (tels que des nanotubes) peut être déposé sur le peigne.

Le catalyseur peut ne pas être déposé de manière uniforme sur le peigne mais être déposé de manière localisée sur une surface inférieure à 500 µm² par dent à l'extrémité de plusieurs dents du peigne. Le support ou peigne peut comprendre une couche d'adhésion pour le nano-objet.

Le peigne peut comprendre des moyens de localisation et/ou de sélection, sur le peigne, de l'objet à transférer. Le peigne peut par exemple comprendre des moyens de mesure de conductivité et/ou de défauts de l'objet à transférer. Dans une dernière variante, les moyens de localisation et/ou de sélection peuvent par exemple comprendre une électrode sur chaque dent ; de préférence de sorte que les deux électrodes d'une paire de dents sont agencées pour mesurer la présence et/ou la conductivité et/ou des défauts de l'objet à transférer situé entre les dents de cette paire.

Suivant encore un autre aspect de l'invention, il est proposé un procédé d'utilisation de cette dernière variante de peigne, dans lequel on surveille ou contrôle une réponse électrique entre les deux électrodes d'une paire de dents.

Suivant encore un autre aspect de l'invention, il est proposé un procédé d'utilisation d'un peigne selon l'invention, dans lequel on localise et/ou sélectionne sur le peigne un objet (de préférence un nano-objet) situé entre deux dents d'une paire de dents par une méthode de spectroscopie Rayleigh. Cette sélection peut comprendre une obtention du caractère métallique ou semi-conducteur de l'objet, la détermination de la présence de défauts sur l'objet, et/ou la chiralité de l'objet.

### Description des figures et modes de réalisation

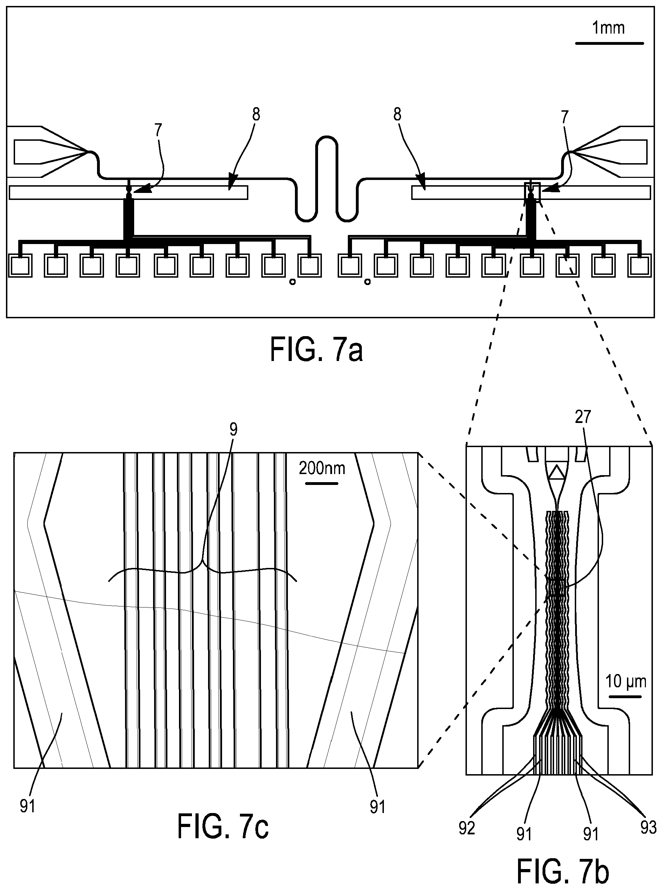

D'autres avantages et particularités de l'invention apparaîtront à la lecture de la description détaillée de mises en œuvre et de modes de réalisation nullement limitatifs, et des dessins annexés suivants :
- la figure 1 est une vue de profil d'un peigne 1 selon l'invention, avec différents agrandissements de certains détails
- la figure 2 est une vue schématique d'un dispositif 2 selon l'invention,
- la figure 3 est une vue schématique en perspective de dents 3 du peigne 1 portant un nano-objet 6 et positionné au-dessus d'un substrat 5
- la figure 4 est une vue schématique de profil de dents 3 du peigne 1 portant le nano-objet 6 et positionné au-dessus du substrat 5
- la figure 5 est une vue de profil plus détaillée substrat 5, notamment d'une zone de dépôt 7
- la figure 6 illustre :
   * en figure 6a une photo de la zone de dépôt 7 et de ses électrodes 91, 92, 93
   * en figure 6b une augmentation de courant électrique entre la paire 92 d'électrodes jusqu'à la rupture ou coupe 25 du nano-objet 6 entre les électrodes de la paire 92
   * en figure 6c une augmentation de courant électrique entre la paire 93 d'électrodes jusqu'à la rupture ou coupe 26 du nano-objet 6 entre les électrodes de la paire 93
- la figure 7 illustre :
   * sur sa partie (a) une variante de substrat 5 comprenant deux fosses et deux zones de dépôts 7
   * sur sa partie (b) un agrandissement d'une des zones de dépôt 7
   * sur sa partie (c) un agrandissement de la partie 27 de la figure 7(b).

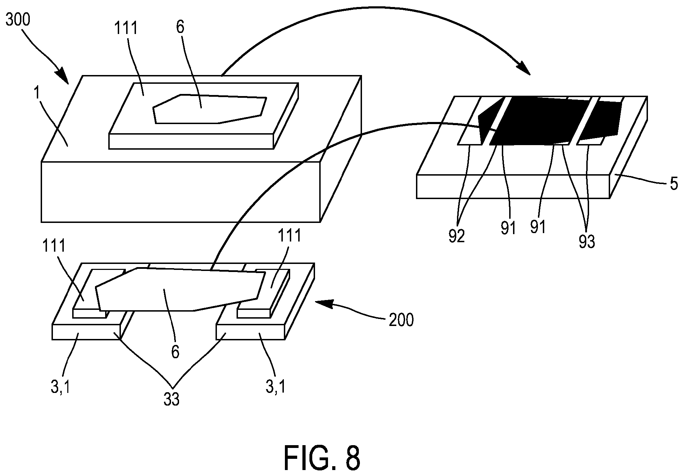

- la figure 8 illustre une variante de peigne, de dispositif et de procédé selon l'invention.

Ces modes de réalisation étant nullement limitatifs, on pourra notamment considérer des variantes de l'invention ne comprenant qu'une sélection de caractéristiques décrites ou illustrées par la suite isolées des autres caractéristiques décrites ou illustrées (même si cette sélection est isolée au sein d'une phrase comprenant ces autres caractéristiques), si cette sélection de caractéristiques est suffisante pour conférer un avantage technique ou pour différencier l'invention par rapport à l'état de la technique antérieure. Cette sélection comprend au moins une caractéristique de préférence fonctionnelle sans détails structurels, et/ou avec seulement une partie des détails structurels si cette partie uniquement est suffisante pour conférer un avantage technique ou à différencier l'invention par rapport à l'état de la technique antérieure.

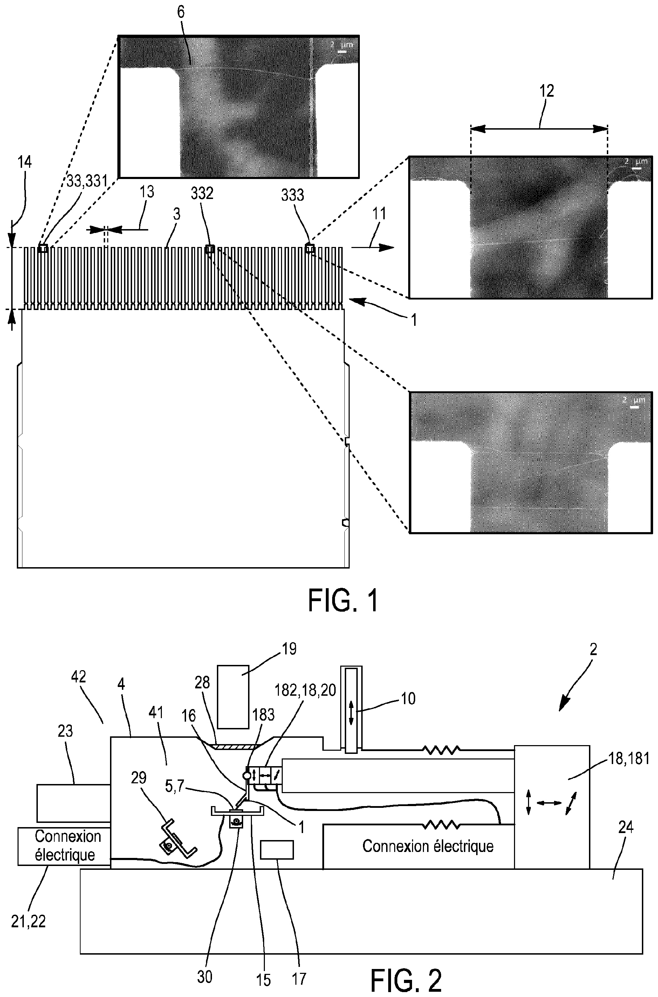

On va tout d'abord décrire, en référence à la figure 1, un peigne 1 selon l'invention.

Le peigne 1 comprend au moins deux dents 3, dont une paire 33 de dents voisines 3 porte un nano-objet 6 à transférer étendu ou suspendu entre les deux dents 3 de la paire 33.

On utilise le terme de nano-objet dans le cas d'un objet ayant au moins une de ses dimensions externes (typiquement parmi sa hauteur, largeur, épaisseur, longueur) inférieure à 100 nm:
- si ses trois dimensions externes (définies selon trois axes orthogonaux) sont inférieures à 100 nm : c'est une nanoparticule
- si deux de ses dimensions externes (de préférence définies selon deux axes orthogonaux) sont inférieures à 100 nm : c'est par exemple un nanotube creux mono ou multi paroi et qui peut être fermé à au moins une extrémité ou une nano-fibre c'est-à-dire une fibre pleine. Une nano-fibre électriquement conductrice ou semi-conductrice sera dénommée par la suite un nano-fil.
- Si une dimension externe est inférieure à 100 nm (typiquement son épaisseur), c'est un nano-feuillet

Sur l'exemple illustré sur la figure 1, le nano-objet 6 à transférer est un nanotube de carbone, i.e. une seule couche d'atomes de carbone enroulée sur elle-même.

Le peigne 1 est un parallélépipède rectangle dont une des extrémités comprend toutes les dents 3 alignées.

Le peigne 1 est typiquement un multicouche formés par des couches de successives de Si, SiO₂, Si, et Si₃N₄.

Le peigne 1 comprend au moins cinq dents 3, de préférence au moins vingt-cinq dents 3. L'exemple de la figure 1 illustre un peigne 1 avec quarante-huit dents 3.

Le peigne 1 a des paires de dents voisines 3 espacées d'un espace régulier 12, défini selon une direction d'alignement 11 des dents 3, supérieure à 5 µm et/ou inférieure à 100 µm, égal à 30µm sur la figure 1.

Le peigne 1 a des dents 3 ayant chacune une largeur 13, définie selon la direction d'alignement 11 des dents 13, supérieure à 5 µm et/ou inférieure à 100 µm, égale à 30µm sur la figure 1.

Chaque dent 3 a une épaisseur (perpendiculairement au plan de la figure 1) d'environ 5 µm.

Les dents 3 sont donc situées le long de la direction 11 avec une périodicité spatiale correspondant à la somme de la distance 12 et de la largeur 13.

Le peigne a des dents 3 ayant chacune une longueur 14, définie selon une direction perpendiculaire à la direction d'alignement 11 des dents, supérieure à 5 µm et/ou inférieure à 1000 µm, égale à 500µm sur la figure 1.

Le peigne 1 est réalisé par différentes étapes de gravure et de lithographie optique.

Le peigne 1 avec ses dents 3 de tailles micrométriques forme un support qui a le moins de matière possible, et :
- permet des contraintes minimales de surface de contact entre le peigne 1 et le substrat cible 5 lors du transfert mécanique.
- est plus ergonomique pour une analyse Rayleigh des nanotubes, surtout dans une géométrique à 90°, car moins de signal parasite venant de la diffusion du peigne 1.

La largeur des dents 3 permet des lithographies qui permettent de localiser le catalyseur qui amorcent la croissance des nanotubes.

Le peigne 1 est adapté à l'invention fonctionnant sous vide. La présence de plusieurs dents 3 permet de disposer de plusieurs objets 6 et ainsi pouvoir en transférer sous vide les uns après les autres (soit en réessayant, soit à des endroits différents) sans casser le vide.

Le mode de réalisation de procédé selon l'invention illustré comprend, avant l'étape d'approche décrite par la suite, un dépôt ou une croissance de nanotubes de carbone 6 sur le peigne 1.

Ce dépôt comprend :
- un dépôt de catalyseur sur le peigne 1, puis
- une croissance des nanotubes 6 sur le peigne 1 en solution ou de préférence par évaporation.

Cette croissance peut être effectuée à l'extérieur ou à l'intérieur de l'enceinte 4 décrite par la suite. Elle est de préférence effectuée dans un four de croissance, en présence de CH₄, H₂ et Ar, porté à 900°C.

Si cette croissance est effectuée à l'intérieur de l'enceinte, le procédé selon l'invention comprend de préférence une conservation du vide à une pression inférieure à 10⁻⁶ bar de la fin l'étape de croissance jusqu'à l'étape de transfert, de préférence jusqu'à l'étape d'encapsulation (décrite par la suite) sous vide à une pression inférieure à 10⁻⁶ bar du nano-objet 6 transféré dans la zone de dépôt 7.

Ainsi, les nanotubes de carbone sont formés directement sur le peigne 1 en déposant du catalyseur en solution liquide sur le peigne 1.

Le catalyseur (typiquement une solution de Fe(NO₃)₃, MoO₂, Al₂O₃ ) est déposé :
- soit de manière uniforme,
- soit de manière non uniforme sur le peigne 1, i.e. il est déposé de manière localisée sur une surface inférieure à 500 µm² par dent 3 à l'extrémité de plusieurs dents 3 du peigne 1, de préférence à l'extrémité de chaque dent 3 du peigne 1, typiquement par une méthode de lithographie optique.

L'étape de croissance est obtenue par dépôt chimique en phase vapeur (CVD) à 900°C sous un flux de méthane et d'hydrogène et d'argon.

L'évaporation permet le dépôt contrôlé et unique d'un nano-objet, le procédé comprenant une surveillance de la réponse électrique de l'objet 6. L'objet 6 est sensible à l'absorption d'une unique molécule. La réponse est suivie entre les dents 3 de la paire 33 grâce à la présence d'électrodes sur le peigne 1 réalisées avant la croissance de l'objet 6.

Le support ou peigne 1 peut comprendre une couche d'adhésion pour un nano-objet, comme par exemple un polymère d'adhésion.

Le mode de réalisation de procédé selon l'invention illustré comprend, avant l'étape d'approche décrite par la suite, une étape de localisation et de sélection, sur le peigne 1, du nano-objet 6 à transférer.

On voit en effet comme illustré sur la figure 1 que le peigne 1 est porteur de plusieurs objets, mais que :
- Les nano-objets entre la paire 333 de dents 33 semblent trop nombreux
- Le nano-objet entre la paire 332 de dents 33 semble trop loin de l'extrémité des dents 3 de cette paire 332.

La sélection comprend :
- une mesure d'une présence de l'objet 6, et/ou
- une mesure de conductivité de l'objet 6 (comprenant une quantification de cette conductivité et/ou une détermination d'un statut tel que métallique ou semi-conducteur de l'objet 6), et éventuellement une mesure de son gap s'il est semi-conducteur et/ou
- une mesure de chiralité de l'objet 6et/ou
- une mesure de défauts de l'objet 6et/ou
- une mesure d'une taille de l'objet 6et/ou de nombre de couches atomiques de l'objet 6 à transférer,
pour vérifier ses propriétés et/ou le départager parmi plusieurs objets 6 parmi les différentes paires de dents 33.

Ainsi typiquement, au moins une de ces sélections est mise en œuvre :
- par une méthode optique, de préférence de spectroscopie Rayleigh,
- par les électrodes portées par le peigne 1 (sauf en ce qui concerne la chiralité)

En pratique, au moins une de ces sélections est mis en œuvre par une méthode de spectroscopie Rayleigh (plus précise), les électrodes du peigne (moins précises) étant plutôt utilisées pour la surveillance de d'apparition de défauts (notamment de défauts souhaités tels que des fonctionnalisations moléculaires) lors d'une étape de croissance de l'objet 6 (tel qu'un nanotube de carbone).

On va maintenant décrire, en référence à la figure 2, un dispositif 2 selon l'invention de dépôt ou transfert ou intégration d'un objet 6.

Le dispositif 2 comprend une enceinte 4. Cette enceinte 4 est une enceinte fermée, du moins dans une position d'utilisation du dispositif 2 notamment lors de l'étape de transfert.

L'enceinte est typiquement en dural.

Cette enceinte 4 est agencée pour résister à une différence de pression entre son intérieur 41 et son extérieur 42 d'au moins 1 bar (son intérieur 41 étant en dépression par rapport à son extérieur 42).

Le dispositif 2 comprend des moyens 16 (tel un réceptacle avec des moyens de fixation du peigne 1) agencés pour porter, dans une zone de support (aussi appelée « zone de peigne » dans le cas où le support 1 est un peigne 1), le peigne 1 comprenant au moins deux dents 3 de la paire 33 portant l'objet 6.

Par « zone de support » ou « zone de peigne », on entend une zone agencée pour accueillir et porter respectivement le support 1 ou peigne 1.

Le dispositif 2 comprend des moyens 15 (telle une plateforme) agencés pour porter un substrat 5 dans une zone de dépôt 7.

Le dispositif 2 comprend des moyens de mise sous vide 17 agencés pour créer dans l'enceinte 4 un vide à une pression inférieure à 10⁻⁶ bar, de préférence inférieure à 5.10⁻⁷ bar.

Les moyens de mise sous vide comprennent typiquement une pompe de type turbo-moléculaire et une pompe à spirales (pour les vides respectivement secondaire et primaire).

Le dispositif 2 comprend des moyens de manipulation 18 agencés pour approcher, dans l'enceinte 4, la zone de peigne et/ou le peigne en direction de la zone de dépôt 7, de manière à permettre un transfert, dans l'enceinte 4, d'un nano-objet 6 de la zone de peigne vers la zone de dépôt 7 (typiquement alors que la zone de dépôt 7 est insérée entre les deux dents 3 de la paire 33) .

Les moyens de manipulation 18 comprennent au moins une série de micromanipulateurs, chaque série étant agencée pour déplacer les moyens 16 selon trois axes orthogonaux. Sur la figure 2, les moyens de manipulation 18 comprennent deux séries de micromanipulateurs 181, 182 en série et ayant des résolutions spatiales plus fines à proximité des moyens 16. Typiquement, les moyens 18 comprennent des micromanipulateurs associés à des moteurs piézo-électriques (Attocube) permettant le positionnement précis du peigne 1 par rapport au substrat 5.

Les moyens de manipulation 18 comprennent des moyens 183 pour régler les angles (roulis, tangage, lacet autour de trois axes perpendiculaires entre eux) entre :
- la zone de peigne ou le peigne 1 et
- le substrat cible 5 ou la zone de dépôt 7.

Les moyens de manipulation 18 sont agencés pour approcher, dans l'enceinte 4, la zone de peigne en direction de la zone de dépôt 7, de manière à permettre un transfert, dans l'enceinte 4, d'un nano-objet 6 de la zone de peigne vers la zone de dépôt 7 alors que l'intérieur 41 de l'enceinte 4 est dans un vide à une pression inférieure à 10⁻⁶ bar (de préférence inférieure à 5.10⁻⁷ bar ) crée par les moyens de mise sous vide 17.

Le dispositif 2 comprend des moyens de contrôle optique 19 agencés pour contrôler optiquement :
- une inclinaison du peigne 1 par rapport à la zone de dépôt 7, et/ou
- une position relative entre le peigne 1 et la zone de dépôt 7, et/ou
- au moins un angle entre le peigne 1 et la zone de dépôt 7.

Les moyens 19 comprennent typiquement :
- un objectif optique (typiquement x50), et
- une fenêtre 28 (hermétique au gaz mais pas à la lumière collectée par l'objectif) séparant l'intérieur 41 et l'extérieur 42 de l'enceinte, la fenêtre 28 étant disposée entre l'objectif et la zone de dépôt 7 et/ou les moyens 15.

Le dispositif 2 comprend des moyens de réglage 20 (comprenant les moyens 18, 181, 182, 183) agencés pour régler, depuis l'extérieur 42 de l'enceinte 4:
- une inclinaison du peigne 1 par rapport à la zone de dépôt 7 à l'intérieur 41 de l'enceinte 4, et/ou
- une position relative entre le peigne 1 et la zone de dépôt 7 à l'intérieur 41 de l'enceinte 7, et/ou
- au moins un angle (de préférence trois angles atour de trois axes perpendiculaires) entre le peigne 1 et la zone de dépôt 7 à l'intérieur 41 de l'enceinte 7.

Les moyens de réglage 20 sont agencés pour que la zone de peigne puisse être mobile en rotation (atour de trois axes perpendiculaires) et/ou en translation par rapport à l'enceinte 4 alors que la zone de dépôt 7 et/ou le moyen 15 est immobile par rapport à l'enceinte 4.

Le dispositif comprend en outre des moyens 30 pour régler en rotation la position de la zone de dépôt 7 et/ou des moyens 15 par rapport à l'enceinte 4.

Les moyens de manipulation 20 sont agencés pour approcher, dans l'enceinte 4, la zone de peigne en direction de la zone de dépôt 7, de manière à permettre un transfert, dans l'enceinte 4, d'un nano-objet 6 de la zone de peigne vers la zone de dépôt 7 alors que l'intérieur 41 de l'enceinte 4 est à une température supérieure à -50°C et/ou inférieure à +90°C, et/ou alors que la température à l'intérieur 41 de l'enceinte 4 est égale à une température de l'air à l'extérieur 42 de l'enceinte 4.

Le dispositif 2 comprend des moyens d'encapsulation 29 agencés pour encapsuler, dans l'enceinte 4 et sous vide à une pression inférieure à 10⁻⁶ bar ( de préférence inférieure à 5.10⁻⁷ bar) , un nano-objet 6 transféré dans la zone de dépôt 7.

Par encapsulation, on entend une protection de l'objet 6 d'un contact direct avec une atmosphère lorsque l'on remet l'intérieur de l'enceinte 4 à cette atmosphère ayant une pression supérieure à 10⁻⁶ bar.

Le dispositif 2 comprend des moyens électriques et/ou électroniques 21 (partant des moyens 15 vers l'extérieur de l'enceinte 4) agencés pour se connecter à :
- des électrodes (dont au moins deux électrodes de mesure 91 et/ou au moins deux paires 92, 93 d'électrodes de coupe), et/ou
- un circuit 9
situé(es) dans la zone de dépôt 7 et porté(es) par le substrat 5 placé sur les moyens 15.

Les moyens électriques et/ou électroniques 21 comprennent des moyens pour effectuer une mesure électrique entre deux électrodes de mesure 91 situées dans la zone de dépôt.

Les moyens 21 comprennent typiquement :
- Un générateur de courant et/ou un générateur de tension, et
- Respectivement un voltmètre et/ou un ampèremètre (et/ou une détection synchrone).

Les moyens électriques et/ou électroniques 21 comprennent des moyens 22 pour faire circuler un courant (d'au moins 20 µA ) ou générer une tension (d'au moins 5 mV ou même 10 mV) entre la paire d'électrodes de coupe 92 situées dans la zone de dépôt 7 de manière à couper un nano-objet 6 entre la paire d'électrodes de coupe 92.

Les moyens électriques et/ou électroniques 21 comprennent des moyens 22 pour faire circuler un courant (d'au moins 20 µA ) ou générer une tension (d'au moins 5 mV ou même 10 mV) entre la paire d'électrodes de coupe 93 situées dans la zone de dépôt 7 de manière à couper un nano-objet 6 entre la paire d'électrodes de coupe 93.

Les paires d'électrodes de coupes respectivement 92 et 93 sont situées aux extrémités de la zone de dépôt 7.

Le dispositif 2 comprend des moyens de nettoyage 23 agencés pour nettoyer la zone de dépôt 7 à l'intérieur de l'enceinte 4, les moyens de nettoyage comprenant de préférence :
- un canon à ions, de préférence un canon à ions Argon, et/ou
- des moyens de décapage agencés pour décaper une couche protectrice par un plasma qui grave sélectivement cette couche protectrice.

Le dispositif 2 comprend une vanne 10 agencée pour :
- dans une position ouverte (illustrée sur la figure 1), ne pas isoler la zone de peigne par rapport à la zone de dépôt 7, et
- dans une position fermée (dans laquelle, par rapport à la figure 1, les moyens de manipulation 18 positionnent les moyens 16 à droite de la figure 2), isoler la zone de peigne par rapport à la zone de dépôt 7.

Ainsi la vanne 10 est agencée pour créer une isolation entre :
- le réceptacle 16 sur lequel est l'objet 6, et
- l'intérieur 41 de l'enceinte 4.

Le dispositif 2 est monté sur une table à coussin d'air 24. Cela permet de réduire les vibrations (notamment du système de pompage 17).

On va maintenant décrire, en référence aux figures 1 à 7, un mode de réalisation de procédé selon l'invention de dépôt ou transfert ou intégration d'un objet 6.

Tout d'abord, on place :
- le peigne 1 sur son réceptacle 16
- le substrat 5 sur son réceptacle 15.

On ferme ensuite l'enceinte 4 de manière hermétique.

On réalise un vide secondaire dans l'enceinte 4, par les moyens 17, à une pression inférieure à 10⁻⁶ bar, de préférence inférieure à 5.10⁻⁷ bar, typiquement égale à 10⁻⁷ bar.

Ce mode de réalisation de procédé selon l'invention comprend ensuite, avant l'étape d'approche décrite par la suite, un nettoyage de la zone de dépôt 7 à l'intérieur de l'enceinte 4 par :
- les moyens 23 comprenant de préférence un canon à ions, de préférence un canon à ions Argon, et/ou
- par un décapage d'une couche protectrice avec un plasma qui grave sélectivement cette couche protectrice.

L'étape de nettoyage est réalisée alors que l'intérieur 41 de l'enceinte 4 est sous vide à une pression inférieure à 10⁻⁶ bar, de préférence inférieure à 5.10⁻⁷ bar.

Le vide à une pression inférieure à 10⁻⁶ bar (de préférence inférieure à 5.10⁻⁷ bar) est conservé de l'étape de nettoyage jusqu'à l'étape de transfert.

Le peigne 1 est isolé (dans une zone dite zone tampon) de la partie de l'intérieur 41 de l'enceinte comprenant le substrat 5 par une vanne fermée 10 lors de l'étape de nettoyage.

Ce nettoyage permet un couplage optimal entre l'objet 6 et le substrat 5.

Ensuite, on ouvre la vanne 10.

Ce mode de réalisation de procédé de dépôt (ou d'intégration ou de transfert) d'un nano-objet 6 selon l'invention comprend ensuite une approche, dans l'enceinte 4, du peigne 1 en direction d'un substrat porteur 5 porté par les moyens 15.

La zone de dépôt 7 correspond à une partie du substrat 5. L'approche comprend un contrôle optique par les moyens 19 :
- d'une inclinaison du peigne 1 par rapport à la zone de dépôt 7, et/ou
- d'une position relative entre le peigne 1 et la zone de dépôt 7, et/ou
- d'au moins un angle entre le peigne 1 et la zone de dépôt 7.

Ainsi, le contrôle optique n'est pas seulement celui de l'inclinaison mais aussi de la position relative, ainsi que les angles (roulis, tangage, lacet), entre le peigne 1 et le substrat cible 5.

Ces trois angles (roulis, tangage, lacet), sont ajustables même lorsque l'enceinte 4 est fermée. Ce positionnement des angles est intéressant car il permet d'accéder à des propriétés originales des nanoobjets. Par exemple, deux feuilles de graphène superposées avec un angle de 1.1° deviennent supraconductrices.

L'inclinaison entre le réceptacle 16 et le substrat cible 5 est importante ici pour minimiser la surface de contact entre les dents 3 du peigne 1 et le substrat cible 5.

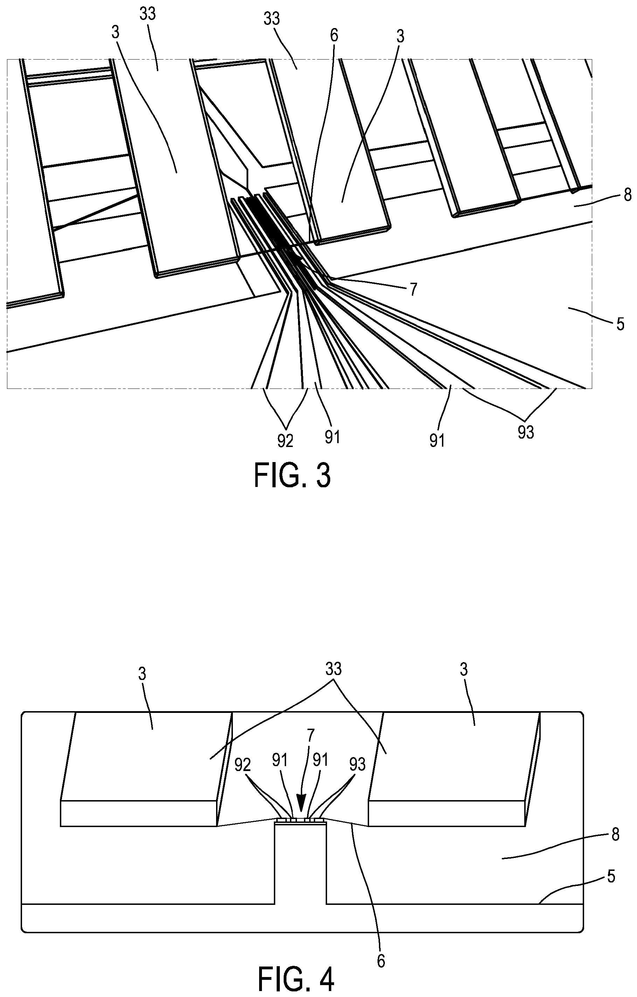

Comme illustré sur la figure 3, ce mode de réalisation de procédé selon l'invention comprend ensuite un réglage, par les moyens 20, et depuis l'extérieur de l'enceinte 4 :
- d'une inclinaison du peigne 1 par rapport à la zone de dépôt 7 à l'intérieur 41 de l'enceinte 4, et/ou
- d'une position relative entre le peigne 1 et la zone de dépôt 7 à l'intérieur 41 de l'enceinte 4, et/ou
- d'au moins un angle entre le peigne 1 et la zone de dépôt 7 à l'intérieur 41 de l'enceinte 4.

Pendant l'étape de réglage :
- le peigne 1 est mobile par rapport à l'enceinte 4, et
- la zone de dépôt 7 est immobile par rapport à l'enceinte 4.

Ainsi, on lève une contrainte, car la zone de dépôt 7 ne doit pas être nécessairement sous forme de pointe. Le peigne 1, mobile, peut s'insérer de façon minimale autour de la zone de dépôt 7.

Ensuite, comme illustré sur la figure 4, ce mode de réalisation de procédé selon l'invention comprend un transfert mécanique , dans l'enceinte 4, du nano-objet 6 de la paire 33, 331 à partir du support 1 et vers la zone de dépôt 7 du substrat porteur 5.

Ce transfert est mis en œuvre à partir du peigne 1 alors que la zone de dépôt 7 est insérée entre les deux dents 3 de la paire 33.

Ainsi, le transfert mécanique s'effectue à la fin de la fabrication de l'ensemble composé par le substrat 5 et l'objet 6, ce qui permet de préserver le nano-objet 6 vierge de tout résidu chimique.

Le substrat porteur 5 comprend, de part et d'autre de la zone de dépôt 7, des (deux) fosses 8 dans lesquelles sont insérées les dents 3 du peigne 1 lors du transfert.

Les fosses 8 sont creusées dans le substrat 5 de part et d'autres de l'endroit où le nano-objet 6 doit être déposé. Chaque fosse 8 fait 2mm de long, 200 µm de large et 15 µm de profondeur.

Le substrat porteur 5 comprend dans cet exemple non limitatif un substrat de silicium.

L'étape de transfert (ainsi que l'étape d'approche) est réalisée alors que l'intérieur 41 de l'enceinte 4 est sous vide à une pression inférieure à 10⁻⁶ bar, de préférence inférieure à 5.10⁻⁷ bar.

Le transfert mécanique s'effectue donc sous vide, ce qui assure un contact propre entre l'objet 6 et le substrat 5, ce qui assure un meilleur couplage, une plus grande stabilité, et une intégration quasi systématique.

Le transfert (ainsi que l'étape d'approche) est réalisé à une température à l'intérieur 41 de l'enceinte 4 :
- supérieure à -50°C, de préférence supérieure à 0°C, de préférence supérieure à 10°C et/ou
- inférieure à +90°C, de préférence inférieure à 40°C, de préférence inférieure à 30°C.

Par « température de l'enceinte » ou « température à l'intérieur de l'enceinte », on entend de préférence au moins la température des parois intérieures de l'enceinte 4 en contact avec l'atmosphère à l'intérieur 41 de l'enceinte 4. Localement, le réceptacle 15 et/ou le substrat 5 et/ou la zone de dépôt 7 peut être refroidi (par exemple par un doigt froid) ou réchauffé (par exemple par une résistance).

Pendant le transfert (ainsi que pendant l'étape d'approche), la température à l'intérieur 41 de l'enceinte 4 est égale à une température de l'air à l'extérieur 42 de l'enceinte 4 et/ou à l'extérieur du dispositif 2.

Autrement dit, le transfert (ainsi que l'étape d'approche) a lieu à température ambiante, de préférence entre 10° et 30°, typiquement entre 17 et 27°C

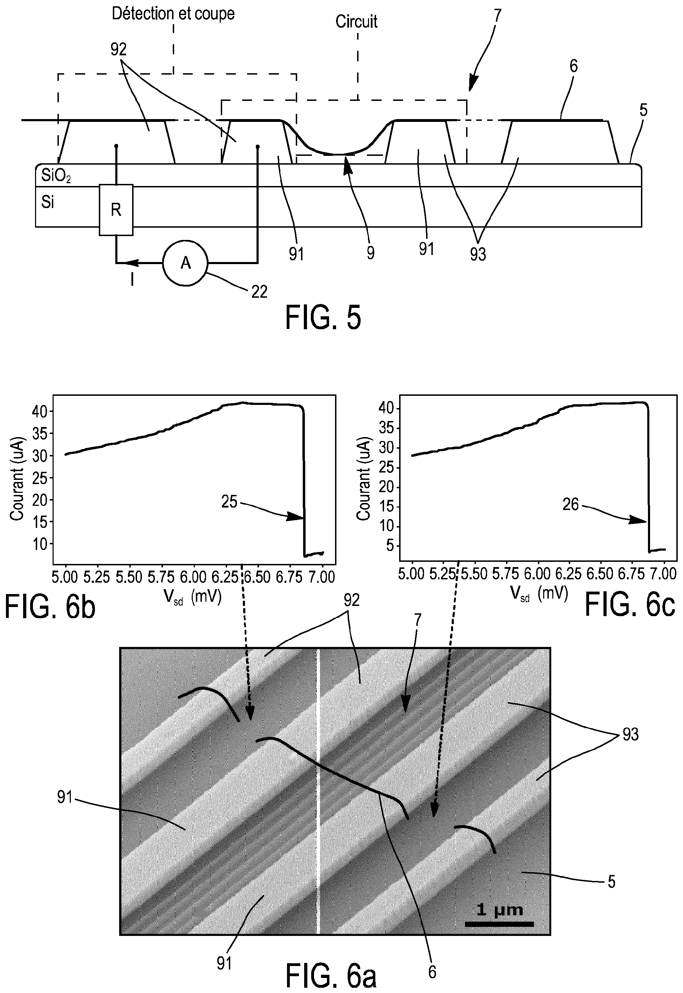

Comme illustré sur la figure 5, la zone de dépôt 7 comprend :
- des électrodes 91, 92, 93, et/ou
- un circuit 9 typiquement électronique et/ou photonique et/ou micro-fluidique que le substrat 5 porte,
de sorte que ces électrodes (et/ou le circuit 9, en fonction de la hauteur des électrodes) soient en contact, à la fin de l'étape de transfert, du nano-objet 6 transféré.

Les électrodes 91, 92, 93 comprennent deux électrodes de mesure 91 situées sur le substrat 5 dans la zone de dépôt 7.

Ce mode de réalisation de procédé selon l'invention comprend pendant l'étape de transfert, une mesure électrique entre les deux électrodes de mesure 91 de la zone de dépôt 7, typiquement une mesure de tension ou de courant entre les deux électrodes de mesure 91. Cela permet de vérifier la présence de l'objet 6 entre les électrodes 91 et son contact avec les électrodes 91.

Le contact entre l'objet 6 et le substrat 5 est détecté en mesurant en continue le courant électrique entre les deux électrodes 91 (ce courant devenant non nul lorsque l'objet 6 touche les deux électrodes 91).

Après le contact du nano-objet 6 et du substrat 5, et avant la coupe décrite par la suite, on caractérise le nano-objet 6, ainsi que son contact avec le substrat cible 5, par des mesures électriques ; si ces mesures ne conviennent pas, on peut essayer avec un autre nano-objet plus loin sur le peigne 1. On peut mesurer les caractéristiques électroniques du nanotube 6 en contact tel que précédemment décrit: métallique, semi-conducteur, taille du gap, défauts, etc.

Les électrodes 91, 92, 93 comprennent dans la zone de dépôt deux paires d'électrodes dites de coupe 92, 93.

Les deux paires 92 et 93 encadrent les électrodes 91.

Une des électrodes de la paire 92 est de préférence confondue avec une des électrodes 91 et une des électrodes de la paire 93 est de préférence confondue avec l'autre électrode 91.

Le transfert comprend une circulation de courant entre chaque paire 92, 93 d'électrodes de coupe de manière à couper le nano-objet 6 entre chaque paire d'électrodes de coupe.

La figure 6 illustre :
* en figure 6a une photo de la zone de dépôt 7 et de ses électrodes 91, 92, 93
* en figure 6b une augmentation de courant électrique (par les moyens 22) entre la paire 92 d'électrodes jusqu'à la rupture ou coupe 25 du nano-objet 6 entre les électrodes de la paire 92
* en figure 6c une augmentation de courant électrique (par les moyens 22) entre la paire 93 d'électrodes jusqu'à la rupture ou coupe 26 du nano-objet 6 entre les électrodes de la paire 93

On coupe l'objet 6 à deux endroits situés entre les dents 3 de la paire 33 de manière à le séparer du peigne 1 et l'accrocher au substrat 5.

La coupe donne une information sur l'objet transféré 6. Si par exemple il y a plusieurs nanotubes, ils vont se couper pour des valeurs de courant électrique différentes : il y aura des marches dans la diminution brutale du courant indiquant la coupe.

Un avantage que possède ce mode de réalisation de l'invention par rapport à l'état de l'art est de pouvoir retirer le nano-objet 6 avec le plasma Ar qui est in-situ en protégeant le peigne 1 dans la zone tampon. On peut ainsi recommencer l'opération.

Suite à la découpe, ce mode de réalisation de procédé selon l'invention comprend donc une étape de vérification d'une nature et/ou d'une qualité du nano-objet déposé 6 (cette qualité étant par exemple un nombre de marches de sauts de courant mesurés pendant la coupe) et en cas de non qualité (par exemple en cas de nombre de sauts supérieur à 1 ; ou supérieur à un seuil supérieur et/ou inférieur à un seuil inférieur) :
- renvoi du support 1 dans la zone tampon
- fermeture de la zone tampon par la vanne 10
- nettoyage de la zone de dépôt 7 par les moyens 23
- ouverture de la vanne 10 et sortie du support 1
- réitération de l'étape de transfert.

On remarque que le procédé selon l'invention peut comprendre un déplacement du peigne 1 par les moyens 18 entre différentes réitérations d'un transfert d'objet 6 tel que décrit précédemment, de manière à :
- déposer plusieurs nano-objets 6 (initialement portés par le peigne 1 entre différentes paires de dents 3) à différents endroits du substrat 5 ; par exemple, comme illustré sur la figure 7, le substrat peut dans certaines variantes comprendre plusieurs zones de dépôt 7 telles que la zone de dépôt 7 précédemment décrite et/ou
- empiler plusieurs nano-objets 6 (initialement portés par le peigne 1 entre différentes paires de dents 3) sur le substrat 1,
et cela sans casser le vide créer par les moyens 17.

La figure 7 illustre un substrat ayant pour chaque zone de dépôt 7 une architecture de Q-bit quantique (les deux zones 7 étant reliées par un système de couplage), compatible avec l'invention. La mise en œuvre de l'invention pour le dépôt d'un nanotube de carbone sur chaque zone 7 sur une telle architecture améliore d'un facteur d'environ 100 le temps de vie caractéristique d'une excitation quantique par rapport à un dépôt de nanotube de carbone sur cette même architecture mais par un procédé selon l'état de l'art. La limite intrinsèque du bruit pour les excitations quantiques , fixée par la proportion d'atomes de carbone 13 dans le nanotube est ainsi atteinte selon l'invention, soulignant la grande propreté du dispositif.

Ensuite, ce mode de réalisation de procédé selon l'invention comprend une encapsulation, à l'intérieur 41 de l'enceinte 4 et sous vide à une pression inférieure à 10⁻⁶ bar (de préférence inférieure à 5.10⁻⁷ bar), du nano-objet 6 transféré.

Deux types d'encapsulation sont possibles :
- une encapsulation hermétique du nano objet 6 transféré où tout le substrat cible 5 est conservé sous le vide (L'encapsulation peut être faite en fermant un couvercle hermétique sur le substrat cible 5, par exemple en utilisant un couvercle monté sur une tige à rotule à l'intérieur de l'enceinte 4), ou
- une encapsulation seulement du nano objet 6 transféré en le recouvrant d'un matériau ou d'un nanomatériau qui permet d'isoler le nano objet 6 de l'atmosphère ambiante.

Dans une suite du procédé, on peut alors transporter le nano-objet 6 encapsulé sous vide et restant constamment sous vide, par exemple en le sortant de l'enceinte 4 et en le plaçant dans un autre équipement, par exemple dans un cryostat.

On va maintenant décrire, en référence à la figure 8, une variante de peigne 1, une variante de dispositif 2 et une variante de procédé selon l'invention.

Ces variantes ne seront décrites que pour leurs différences par rapport à celles précédemment décrites en référence aux figures 1 à 7.

Dans ces variantes, le nano-objet 6 est une hétérostructure bidimensionnelle ou un nano-feuillet, et comprend typiquement du graphène.

Comme dans le cas du nano-tube des précédentes figures, l'objet 6 illustré sur la figure 8 est transféré sous vide en étant porté par un support 1, plus précisément en étant porté :
- entre deux dents 3 du support ou peigne 1 (cas référencé 200), de préférence alors que la zone de dépôt 7 est située entre les dents 3, ou
- sur un support 1 plat (cas référencé 300).

L'objet 6 est porté par le support 1 de préférence par l'intermédiaire d'un polymère d'adhésion 111.

L'utilisation du peigne 1 permet d'éviter de contaminer le graphène 6 déposé (sur les électrodes 91 et/ou le circuit 9) avec le polymère d'adhésion 111.

Comme précédemment, l'objet 6 est découpé par les paires 92, 93 et détaché du support 1.

De manière très avantageuse, la coupe peut s'effectuer pour un objet 6 comprenant des matériaux bidimensionnels conducteurs. Elle permet de détacher uniquement une première couche si le matériau est constitué de plusieurs feuillets sur le peigne 1 et que l'on souhaite détacher du peigne 1 vers le substrat 5 uniquement le premier feuillet.

L'invention permet une intégration d'un nano-objet 6 sur le substrat 5 quasi systématique et non destructive.

L'invention réduit les contaminations et les dégradations pouvant provenir de procédés chimiques, et améliore donc les performances et l'accordabilité de l'objet 6 assemblé au substrat 5.

L'invention permet en outre de choisir l'objet 6 assemblé au substrat 5.

Grâce à l'atmosphère contrôlée dans l'enceinte 4, la connexion entre l'objet 6 et le substrat 5 est optimale.

L'invention permet de transférer mécaniquement un nanotube de carbone 6 avec un taux de succès proche de 100%, i.e. avec une grande efficacité.

L'invention permet de transférer un nano objet 6 en conservant une flexibilité sur le substrat cible 5, i.e. avec le minimum de contraintes sur le substrat cible 5.

L'invention permet de transférer un nano objet 6 avec une rapidité dans son exécution grâce au contrôle optique.

Le transfert mécanique préserve la cristallinité du nano-objet 6.

En outre le peigne 1 permet de pouvoir tester un grand nombre d'objets 6, préalablement caractérisés optiquement typiquement par la méthode de Rayleigh.

Le peigne 1 présente l'avantage de pouvoir manipuler l'objet 6 vierge de tout défaut et de tout résidu. Par exemple, fonctionnaliser un nanotube avec une molécule unique revient à ajouter un défaut de manière contrôlée. Il est donc avantageux d'avoir un nanotube vierge sans défauts afin que ceux-ci n'entrent pas en compétition avec l'effet de la molécule unique sur le nanotube 6.

Les applications de l'invention sont multiples, que cela soit pour fabriquer :
- un circuit quantique : le nanotube 6 peut servir à créer une boîte quantique (dans lequel un électron est piégé dans les trois dimensions) ou un canal unidimensionnel pour des électrons.
- un composant opto-électronique : le nanotube 6 peut servir pour une source de photons uniques.
- un Nano-transistor .
- autres : un dispositif pour le transfert mécanique du graphène, d'hétérostructures bidimensionnelles, de nanofils,...

Bien sûr, l'invention n'est pas limitée aux exemples qui viennent d'être décrits et de nombreux aménagements peuvent être apportés à ces exemples sans sortir du cadre de l'invention.

Ainsi, dans des variantes combinables entre elles des modes de réalisation précédemment décrits :
le nano-objet à transférer peut être un nanotube ou une nano-fibre ou un nano-fil ou du graphène ou une hétérostructure bidimensionnelle (c'est-à-dire superposition de couches de graphène ou d'autres matériaux bidimensionnels comme le Nitrure de Bore Hexagonal (h-BN)) ou un nano-feuillet.

Bien entendu, les différentes caractéristiques, formes, variantes et modes de réalisation de l'invention peuvent être associées les unes avec les autres selon diverses combinaisons dans la mesure où elles ne sont pas incompatibles ou exclusives les unes des autres. En particulier toutes les variantes et tous les modes de réalisation décrits précédemment sont combinables entre eux.

## Revendications

1. Procédé de dépôt d'un objet comprenant:
- une approche, dans une enceinte (4), d'un peigne (1) en direction d'un substrat porteur (5), le peigne comprenant au moins deux dents (3), dont une paire (33) de dents voisines porte un objet (6) à transférer étendu entre les deux dents de la paire, puis
- un transfert, dans l'enceinte, de l'objet à partir du peigne et vers une zone de dépôt (7) du substrat porteur alors que la zone de dépôt est insérée entre les deux dents de la paire
**caractérisé en ce que** l'étape de transfert est réalisée alors que l'intérieur de l'enceinte est sous vide à une pression inférieure à 10⁻⁶ bar.

2. Procédé selon la revendication 1, **caractérisé en ce que** l'approche comprend un contrôle optique :
- d'une inclinaison du peigne par rapport à la zone de dépôt, et/ou
- d'une position relative entre le peigne et la zone de dépôt, et/ou
- d'au moins un angle entre le peigne et la zone de dépôt.

3. Procédé selon la revendication 2, **caractérisé en ce que** l'approche comprend un réglage, depuis l'extérieur de l'enceinte :
- d'une inclinaison du peigne par rapport à la zone de dépôt à l'intérieur de l'enceinte, et/ou
- d'une position relative entre le peigne et la zone de dépôt à l'intérieur de l'enceinte, et/ou
- d'au moins un angle entre le peigne et la zone de dépôt à l'intérieur de l'enceinte.

4. Procédé selon la revendication 3, **caractérisé en ce que** pendant l'étape de réglage :
- le peigne est mobile par rapport à l'enceinte, et
- la zone de dépôt est immobile par rapport à l'enceinte.

5. Procédé selon l'une quelconque des revendications précédentes, **caractérisé en ce que** :
- le transfert est réalisé à une température à l'intérieur de l'enceinte supérieure à -50°C et/ou inférieure à +90°C, et/ou
- la température à l'intérieur de l'enceinte est égale à une température à l'extérieur de l'enceinte.

6. Procédé selon l'une quelconque des revendications précédentes, **caractérisé en ce qu'**il comprend une encapsulation, dans l'enceinte et sous vide à une pression inférieure à 10⁻⁶ bar, de l'objet transféré.

7. Procédé selon l'une quelconque des revendications précédentes, **caractérisé en ce que** le substrat porteur comprend, de part et d'autre de la zone de dépôt, des fosses (8) dans lesquelles sont insérées les dents du peigne lors du transfert.

8. Procédé selon l'une quelconque des revendications précédentes, **caractérisé en ce que** la zone de dépôt comprend des électrodes ou un circuit électronique (9), de sorte que ces électrodes et/ou le circuit électronique soit en contact, à la fin de l'étape de transfert, de l'objet à transférer.

9. Procédé selon la revendication 8, **caractérisé en ce qu'**il comprend, pendant l'étape de transfert, une mesure électrique entre deux électrodes de mesure (91) de la zone de dépôt.

10. Procédé selon la revendication 8 ou 9, **caractérisé en ce que** la zone de dépôt comprend deux paires d'électrodes dites de coupe (92, 93), le transfert comprenant une circulation de courant entre chaque paire d'électrodes de coupe de manière à couper l'objet entre chaque paire d'électrodes de coupe.

11. Procédé selon l'une quelconque des revendications précédentes, **caractérisé en ce qu'**il comprend, avant l'étape d'approche, un nettoyage de la zone de dépôt à l'intérieur de l'enceinte, le nettoyage étant réalisé alors que l'intérieur de l'enceinte est sous vide à une pression inférieure à 10⁻⁶ bar, le vide à une pression inférieure à 10⁻⁶ bar étant conservé de l'étape de nettoyage jusqu'à l'étape de transfert.

12. Procédé selon la revendication 11, **caractérisé en ce que** le peigne est isolé du substrat par une vanne fermée (10) lors de l'étape de nettoyage.

13. Procédé selon l'une quelconque des revendications précédentes, **caractérisé en ce que** l'objet à transférer est un nanotube de carbone, un nano-fil et/ou du graphène ou une hétérostructure bidimensionnelle.

14. Procédé selon l'une quelconque des revendications précédentes, **caractérisé en ce que** le peigne :
- comprend au moins cinq dents, de préférence au moins 25 dents, et/ou
- a des paires de dents voisines espacées d'un espace, défini selon une direction d'alignement des dents, supérieure à 5 µm et/ou inférieure à 100 µm, et/ou
- a des dents ayant chacune une largeur, définie selon une direction d'alignement des dents, supérieure à 5 µm et/ou inférieure à 100 µm, et/ou
- a des dents ayant chacune une longueur, définie selon une direction perpendiculaire à la direction d'alignement des dents, supérieure à 5 µm et/ou inférieure à 1000 µm.

15. Procédé selon l'une quelconque des revendications précédentes, **caractérisé en ce qu'**il comprend, avant l'étape d'approche, un dépôt de nanotubes de carbone sur le peigne comprenant :
- un dépôt de catalyseur sur le peigne, puis
- une croissance des nanotubes sur le peigne.

16. Procédé selon la revendication 15, **caractérisé en ce que** le catalyseur n'est pas déposé de manière uniforme sur le peigne mais est déposé de manière localisée sur une surface inférieure à 500 µm² par dent à l'extrémité de plusieurs dents du peigne.

17. Procédé selon l'une quelconque des revendications précédentes, **caractérisé en ce qu'**il comprend, avant l'étape d'approche, une étape de localisation et de sélection, sur le peigne, de l'objet à transférer.

18. Procédé selon la revendication 17, **caractérisé en ce que** la sélection comprend une mesure de conductivité et/ou de chiralité et/ou de défauts de l'objet à transférer.

19. Dispositif de dépôt d'un objet comprenant:
- une enceinte (4)
- des moyens agencés pour porter, dans une zone de peigne, un peigne comprenant au moins deux dents (3),
- des moyens agencés pour porter un substrat dans une zone de dépôt,
- des moyens de mise sous vide agencés pour créer dans l'enceinte un vide à une pression inférieure à 10⁻⁶ bar,
- des moyens de manipulation agencés pour approcher, dans l'enceinte, la zone de peigne en direction de la zone de dépôt, de manière à permettre un transfert, dans l'enceinte, d'un objet à partir de la zone de peigne et vers la zone de dépôt
**caractérisé en ce que** les moyens de manipulation sont agencés pour approcher, dans l'enceinte, la zone de peigne en direction de la zone de dépôt, de manière à permettre un transfert, dans l'enceinte, d'un objet de la zone de peigne vers la zone de dépôt alors que l'intérieur de l'enceinte est dans un vide à une pression inférieure à 10⁻⁶ bar crée par les moyens de mise sous vide.

## Patentansprüche

1. Verfahren zur Ablagerung eines Objekts, umfassend:
- Annäherung, in einem Gehäuse (4), eines Kamms (1) in Richtung eines Trägersubstrats (5), wobei der Kamm mindestens zwei Zähne (3) umfasst, von denen ein Paar (33) benachbarter Zähne ein zu übertragendes Objekt (6) trägt, das sich zwischen den beiden Zähnen des Paares erstreckt, dann
- Übertragung, in dem Gehäuse, des Objekts von dem Kamm in einen Ablagerungsbereich (7) des Trägersubstrats, während der Ablagerungsbereich zwischen die beiden Zähne des Paares eingeführt wird,
**dadurch gekennzeichnet, dass** der Übertragungsschritt durchgeführt wird, während in dem Inneren des Gehäuses ein Vakuum mit einem Druck von weniger als 10⁻⁶ bar herrscht.

2. Verfahren nach Anspruch 1, **dadurch gekennzeichnet, dass** die Annäherung eine optische Steuerung von Folgendem umfasst:
- einer Neigung des Kamms in Bezug auf den Ablagerungsbereich und/oder
- einer relativen Position zwischen dem Kamm und dem Ablagerungsbereich und/oder
- mindestens eines Winkels zwischen dem Kamm und dem Ablagerungsbereich.

3. Verfahren nach Anspruch 2, **dadurch gekennzeichnet, dass** die Annäherung eine Einstellung von außerhalb des Gehäuses von Folgendem umfasst:
- einer Neigung des Kamms in Bezug auf den Ablagerungsbereich in dem Inneren des Gehäuses und/oder
- einer relativen Position zwischen dem Kamm und dem Ablagerungsbereich in dem Inneren des Gehäuses und/oder
- mindestens eines Winkels zwischen dem Kamm und dem Ablagerungsbereich in dem Inneren des Gehäuses.

4. Verfahren nach Anspruch 3, **dadurch gekennzeichnet, dass** während des Einstellschritts:
- der Kamm in Bezug auf das Gehäuse beweglich ist, und
- der Ablagerungsbereich in Bezug auf das Gehäuse unbeweglich ist.

5. Verfahren nach einem der vorhergehenden Ansprüche, **dadurch gekennzeichnet, dass**:
- die Übertragung bei einer Temperatur in dem Inneren des Gehäuses über -50 °C und/oder unter +90 °C durchgeführt wird, und/oder
- die Temperatur in dem Inneren des Gehäuses gleich einer Temperatur außerhalb des Gehäuses ist.

6. Verfahren nach einem der vorhergehenden Ansprüche, **dadurch gekennzeichnet, dass** es eine Einkapselung des übertragenen Objekts in dem Gehäuse und bei einem Vakuum mit einem Druck von weniger als 10⁻⁶ bar umfasst.

7. Verfahren nach einem der vorhergehenden Ansprüche, **dadurch gekennzeichnet, dass** das Trägersubstrat auf beiden Seiten des Ablagerungsbereichs Gräben (8) umfasst, in die die Zähne des Kamms während der Übertragung eingeführt werden.

8. Verfahren nach einem der vorhergehenden Ansprüche, **dadurch gekennzeichnet, dass** der Ablagerungsbereich Elektroden oder eine elektronische Schaltung (9) umfasst, so dass diese Elektroden und/oder die elektronische Schaltung an dem Ende des Übertragungsschritts mit dem zu übertragenden Objekt in Kontakt stehen.

9. Verfahren nach Anspruch 8, **dadurch gekennzeichnet, dass** es während des Übertragungsschritts eine elektrische Messung zwischen zwei Messelektroden (91) des Ablagerungsbereichs umfasst.

10. Verfahren nach Anspruch 8 oder 9, **dadurch gekennzeichnet, dass** der Ablagerungsbereich zwei Paare Schneidelektroden (92, 93) umfasst, wobei die Übertragung einen Stromfluss zwischen jedem Paar Schneidelektroden umfasst, um das Objekt zwischen jedem Paar Schneidelektroden zu schneiden.

11. Verfahren nach einem der vorhergehenden Ansprüche, **dadurch gekennzeichnet, dass** es vor dem Annäherungsschritt eine Reinigung des Ablagerungsbereichs in dem Inneren des Gehäuses umfasst, wobei die Reinigung durchgeführt wird, während in dem Inneren des Gehäuses ein Vakuum mit einem Druck von weniger als 10⁻⁶ bar herrscht, wobei das Vakuum mit einem Druck von weniger als 10⁻⁶ bar von dem Reinigungsschritt bis zu dem Übertragungsschritt aufrechterhalten wird.

12. Verfahren nach Anspruch 11, **dadurch gekennzeichnet, dass** der Kamm während des Reinigungsschritts durch ein geschlossenes Ventil (10) von dem Substrat isoliert wird.

13. Verfahren nach einem der vorhergehenden Ansprüche, **dadurch gekennzeichnet, dass** das zu übertragende Objekt ein Kohlenstoffnanoröhrchen, ein Nanodraht und/oder Graphen oder eine zweidimensionale Heterostruktur ist.

14. Verfahren nach einem der vorhergehenden Ansprüche, **dadurch gekennzeichnet, dass** der Kamm:
- mindestens fünf Zähne, vorzugsweise mindestens 25 Zähne, umfasst, und/oder
- Paare benachbarter Zähne aufweist, die durch einen Abstand voneinander getrennt sind, der in einer Ausrichtungsrichtung der Zähne definiert ist und größer als 5 µm und/oder kleiner als 100 µm ist, und/oder
- Zähne aufweist, die jeweils eine Breite aufweisen, die in einer Ausrichtungsrichtung der Zähne definiert ist und größer als 5 µm und/oder kleiner als 100 µm ist, und/oder
- Zähne aufweist, die jeweils eine Länge aufweisen, die in einer Richtung senkrecht zu der Ausrichtungsrichtung der Zähne definiert ist und größer als 5 µm und/oder kleiner als 1000 µm ist.

15. Verfahren nach einem der vorhergehenden Ansprüche, **dadurch gekennzeichnet, dass** es vor dem Annäherungsschritt eine Ablagerung von Kohlenstoffnanoröhrchen auf dem Kamm umfasst, umfassend:
- eine Ablagerung eines Katalysators auf dem Kamm, dann
- ein Wachstum der Nanoröhrchen auf dem Kamm.

16. Verfahren nach Anspruch 15, **dadurch gekennzeichnet, dass** der Katalysator nicht gleichmäßig auf dem Kamm abgelagert wird, sondern lokal auf einer Fläche von weniger als 500 µm² pro Zahn an dem Ende mehrerer Zähne des Kamms abgelagert wird.

17. Verfahren nach einem der vorhergehenden Ansprüche, **dadurch gekennzeichnet, dass** es vor dem Annäherungsschritt einen Schritt der Lokalisierung und Auswahl des zu übertragenden Objekts auf dem Kamm umfasst.

18. Verfahren nach Anspruch 17, **dadurch gekennzeichnet, dass** die Auswahl eine Messung der Leitfähigkeit und/oder Chiralität und/oder von Defekten des zu übertragenden Objekts umfasst.

19. Vorrichtung zur Ablagerung eines Objekts, umfassend:
- ein Gehäuse (4)
- Mittel, die so angeordnet sind, dass sie in einem Kammbereich einen Kamm tragen, der mindestens zwei Zähne (3) umfasst,
- Mittel, die so angeordnet sind, dass sie ein Substrat in einem Ablagerungsbereich tragen,
- Vakuumiermittel, die so angeordnet sind, dass sie in dem Gehäuse ein Vakuum mit einem Druck von weniger als 10⁻⁶ bar erzeugen,
- Handhabungsmittel, die so angeordnet sind, dass sie den Kammbereich in dem Gehäuse in Richtung des Ablagerungsbereichs nähern, um eine Übertragung eines Objekts aus dem Kammbereich in den Ablagerungsbereich in dem Gehäuse zu ermöglichen,
**dadurch gekennzeichnet, dass** die Handhabungsmittel so angeordnet sind, dass sie sich in dem Gehäuse dem Kammbereich in Richtung des Ablagerungsbereichs nähern, so dass in dem Gehäuse eine Übertragung eines Objekts von dem Kammbereich in den Ablagerungsbereich ermöglicht wird, während in dem Inneren des Gehäuses ein Vakuum mit einem Druck von weniger als 10⁻⁶ bar herrscht, der durch die Vakuumiermittel erzeugt wird.

## Claims

1. Method for depositing an object, comprising:
- moving, in a chamber (4), a comb (1) closer to a carrier substrate (5), the comb comprising at least two teeth (3), a pair (33) of neighbouring teeth of which carries an object (6) to be transferred extended between the two teeth of the pair, then
- transferring, in the chamber, the object from the comb towards a deposition zone (7) of the carrier substrate while the deposition zone is inserted between the two teeth of the pair,
**characterised in that** the transfer step is carried out while the interior of the chamber is under vacuum at a pressure of less than 10⁻⁶ bar.

2. Method according to claim 1, **characterised in that** the moving closer comprises an optical control:
- of an inclination of the comb with respect to the deposition zone, and/or
- of a relative position between the comb and the deposition zone, and/or
- of at least one angle between the comb and the deposition zone.

3. Method according to claim 2, **characterised in that** the moving closer comprises an adjustment, from outside the chamber:
- of an inclination of the comb with respect to the deposition zone inside the chamber, and/or
- of a relative position between the comb and the deposition zone inside the chamber, and/or
- of at least one angle between the comb and the deposition zone inside the chamber.

4. Method according to claim 3, **characterised in that** during the adjustment step:
- the comb is movable with respect to the chamber, and
- the deposition zone is immobile with respect to the chamber.

5. Method according to any one of the preceding claims, **characterised in that**:
- the transfer is carried out at a temperature inside the chamber greater than -50°C and/or less than +90°C, and/or
- the temperature inside the chamber is equal to a temperature outside the chamber.

6. Method according to any one of the preceding claims, **characterised in that** it comprises encapsulating, in the chamber and under vacuum at a pressure of less than 10⁻⁶ bar, the transferred object.

7. Method according to any one of the preceding claims, **characterised in that** the carrier substrate comprises, on either side of the deposition zone, pits (8) into which the teeth of the comb are inserted during the transfer.

8. Method according to any one of the preceding claims, **characterised in that** the deposition zone comprises electrodes or an electronic circuit (9), so that these electrodes and/or the electronic circuit are in contact, at the end of the transfer step, with the object to be transferred.

9. Method according to claim 8, **characterised in that** it comprises, during the transfer step, an electrical measurement between two measurement electrodes (91) of the deposition zone.

10. Method according to claim 8 or 9, **characterised in that** the deposition zone comprises two pairs of "cutting" electrodes (92, 93), the transfer comprising a flow of current between each pair of cutting electrodes so as to cut the object between each pair of cutting electrodes.

11. Method according to any one of the preceding claims, **characterised in that** it comprises, before the step of moving closer, cleaning the deposition zone inside the chamber, the cleaning being carried out while the inside of the chamber is under vacuum at a pressure of less than 10⁻⁶ bar, the vacuum at a pressure of less than 10⁻⁶ bar being maintained from the cleaning step to the transfer step.

12. Method according to claim 11, **characterised in that** the comb is isolated from the substrate by a closed valve (10) during the cleaning step.

13. Method according to any one of the preceding claims, **characterised in that** the object to be transferred is a carbon nanotube, a nanowire and/or graphene or a two-dimensional heterostructure.

14. Method according to any one of the preceding claims, **characterised in that** the comb:
- comprises at least five teeth, preferably at least 25 teeth, and/or
- has pairs of neighbouring teeth spaced apart by a space, defined according to a direction of alignment of the teeth, greater than 5µm and/or less than 100µm, and/or
- has teeth each having a width, defined according to a direction of alignment of the teeth, greater than 5µm and/or less than 100um, and/or
- has teeth each having a length, defined according to a direction perpendicular to the direction of alignment of the teeth, greater than 5µm and/or less than 1000µm.

15. Method according to any one of the preceding claims, **characterised in that** it comprises, before the step of moving closer, depositing carbon nanotubes on the comb, comprising:
- depositing catalyst on the comb, then
- growing the nanotubes on the comb.

16. Method according to claim 15, **characterised in that** the catalyst is not deposited uniformly on the comb but is deposited locally on a surface smaller than 500µm² per tooth at the end of several teeth of the comb.

17. Method according to any one of the preceding claims, **characterised in that** it comprises, before the step of moving closer, a step of locating and selecting, on the comb, the object to be transferred.

18. Method according to claim 17, **characterised in that** the selection comprises a measurement of conductivity and/or chirality and/or defects of the object to be transferred.

19. Device for depositing an object, comprising:
- a chamber (4)
- means arranged to carry, in a comb area, a comb comprising at least two teeth (3),
- means arranged to carry a substrate in a deposition zone,
- vacuum means arranged to create a vacuum in the chamber at a pressure of less than 10⁻⁶ bar,
- handling means arranged to move, in the chamber, the comb zone closer to the deposition zone, so as to allow a transfer, in the chamber, of an object from the comb zone to the deposition zone,
**characterised in that** the handling means are arranged to move, in the chamber, the comb zone closer to the deposition zone, so as to allow a transfer, in the chamber, of an object from the comb zone to the deposition zone while the interior of the chamber is in a vacuum at a pressure of less than 10⁻⁶ bar created by the vacuum means.
